(19)

Europäisches
Patentamt
European
Patent Office
Office européen
des brevets

(11) **EP 1 906 610 B1**

(12) **EUROPEAN PATENT SPECIFICATION**

(45) Date of publication and mention
of the grant of the patent:
**30.05.2012 Bulletin 2012/22**

(51) Int Cl.:
*H04L 1/00* (2006.01)   *H04L 25/03* (2006.01)
*H03M 13/29* (2006.01)

(21) Application number: **06020443.5**

(22) Date of filing: **28.09.2006**

(54) **Process and arrangement for turbo equalization with turbo decoding of signals**

Verfahren und Anordnung zur Turbo-Entzerrung mit Turbodekodierung von Signalen

Procédé et dispositif pour turbo-égalisation avec turbo décodage de signaux

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**02.04.2008 Bulletin 2008/14**

(60) Divisional application:
**10182993.5 / 2 271 039**

(73) Proprietor: **Vodafone Holding GmbH
40213 Düsseldorf (DE)**

(72) Inventor: **Fonseca Dos Santos, André
01187 Dresden (DE)**

(74) Representative: **Müller, Thomas et al
Patentanwalt
Müller & Schubert
Innere Wiener Strasse 13
81667 München (DE)**

(56) References cited:
• **LEE F K H ET AL: "Parallel-trellis turbo equalizers
for sparse-coded transmission over sparse
multipath channels" ICC 2003. 2003 IEEE
INTERNATIONAL CONFERENCE ON
COMMUNICATIONS. ANCHORAGE, AK, MAY 11
- 15, 2003, IEEE INTERNATIONAL CONFERENCE
ON COMMUNICATIONS, NEW YORK, NY : IEEE,
US, vol. VOL. 1 OF 5, 11 May 2003 (2003-05-11),
pages 2943-2947, XP010642984 ISBN:
0-7803-7802-4**

• **OKADA T ET AL: "Turbo equalizer detection for
GFSK digital FM signals" ICC 2002. 2002 IEEE
INTERNATIONAL CONFERENCE ON
COMMUNICATIONS. CONFERENCE
PROCEEDINGS. NEW YORK, NY, APRIL 28 - MAY
2, 2002, IEEE INTERNATIONAL CONFERENCE
ON COMMUNICATIONS, NEW YORK, NY : IEEE,
US, vol. VOL. 1 OF 5, 28 April 2002 (2002-04-28),
pages 2952-2956, XP010590019 ISBN:
0-7803-7400-2**

• **OTNES R ET AL: "On iterative equalization,
estimation, and decoding" ICC 2003. 2003 IEEE
INTERNATIONAL CONFERENCE ON
COMMUNICATIONS. ANCHORAGE, AK, MAY 11
- 15, 2003, IEEE INTERNATIONAL CONFERENCE
ON COMMUNICATIONS, NEW YORK, NY : IEEE,
US, vol. VOL. 1 OF 5, 11 May 2003 (2003-05-11),
pages 2958-2962, XP010642987 ISBN:
0-7803-7802-4**

• **WONG K K Y ET AL: "Bi-directional soft-output
m-algorithm for iterative decoding"
COMMUNICATIONS, 2004 IEEE INTERNATIONAL
CONFERENCE ON PARIS, FRANCE 20-24 JUNE
2004, PISCATAWAY, NJ, USA,IEEE, 20 June 2004
(2004-06-20), pages 792-797, XP010710430 ISBN:
0-7803-8533-0**

• **SU Y T ET AL: "Turbo equalization of nonlinear
TDMA satellite signals" GLOBECOM'02. 2002 -
IEEE GLOBAL TELECOMMUNICATIONS
CONFERENCE. CONFERENCE PROCEEDINGS.
TAIPEI, TAIWAN, NOV. 17 - 21, 2002, IEEE
GLOBAL TELECOMMUNICATIONS
CONFERENCE, NEW YORK, NY : IEEE, US, vol.
VOL. 1 OF 3, 17 November 2002 (2002-11-17),
pages 2860-2864, XP010636269 ISBN:
0-7803-7632-3**

- TUCHLER M ET AL: "Iterative correction of ISI via equalization and decoding with priors" INTERNATIONAL SYMPOSIUM ON INFORMATION THEORY, 2000. PROCEEDINGS. IEEE 25-30 JUNE, 2000, PISCATAWAY, NJ, USA, IEEE, 25 June 2000 (2000-06-25), pages 100-100, XP010509974 ISBN: 0-7803-5857-0
- YEAP B L ET AL: "Comparative study of turbo equalisers using convolutional codes and block-based turbo codes for GMSK modulation" VEHICULAR TECHNOLOGY CONFERENCE, 1999. VTC 1999 - FALL. IEEE VTS 50TH AMSTERDAM, NETHERLANDS 19-22 SEPT. 1999, PISCATAWAY, NJ, USA,IEEE, US, vol. 5, 19 September 1999 (1999-09-19), pages 2974-2978, XP010353415 ISBN: 0-7803-5435-4

**Description**

The present invention relates to a process for turbo equalization with turbo decoding of signals. Furthermore, the present invention relates to an arrangement for turbo equalization with turbo decoding of signals.

The use of an equalizer interacting with a channel decoder has been frequently applied to communications systems that suffer from multipath effects and Additive White Gaussian (AWGN) noise.

When an equalizer iterates in a turbo way (exchanging extrinsic information) with the channel decoder, it is called Turbo Equalization.

When the equalizer iterates with a turbo decoder it can be called Combined Turbo Equalization with Turbo Decoding.

The document "Lee F.K.H et al, Parallel-Trellis Turbo Equalizers for Sparse Coded Transmission over Sparse Multipath Channels - ICC 2003, 2003 IEEE International conference on Communications, Anchorage, May 11-15, 2003, Vol.1 of 5, pages 2943-2947" describes a process for turbo equalization with turbo decoding of signals, wherein one equalization step is performed and one decoder step are performed at each turbo equalizer iteration.

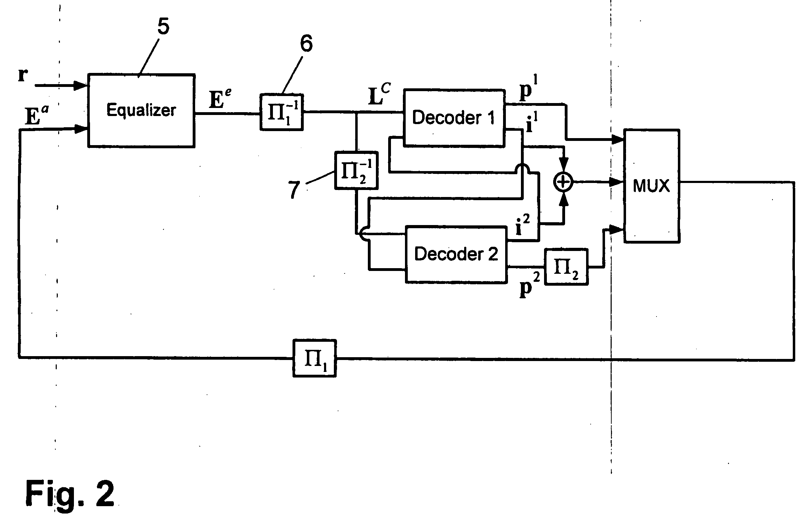

The conventional schedule for a Turbo Equalizer with Turbo Decoding consists of performing one equalization step and several turbo decoding iterations at each turbo equalizer iteration. Such a schedule is described in detail with respect to Figure 2 below. It is a drawback of the known solution that it is highly complex.

Therefore, it is the object of the present invention to provide a low complexity schedule for turbo equalization with turbo decoding.

This object is solved by the process with the features according to independent claim 1. Furthermore, the object is solved by the arrangement with he features according to independent claim 5. Additional features and details of the present invention are evident from the dependent claims, the description as well as from the drawings. Features and details which are described with regard to the process of the present invention are also applicable to the arrangement of the present invention, and vice versa.

The present invention provides a Low complexity schedule for Turbo Equalization with Turbo Decoding.

According to a first aspect the present invention is directed to process for turbo equalization with turbo decoding of signals, whereby one equalization step is performed at each turbo equalizer iteration and one decoder step, which is only one part of a turbo decoder step, is performed at each turbo equalizer iteration, whereby one turbo decoder step is completed when two turbo equalizer iterations have been executed, whereby two decoder steps are performed during one turbo decoder step, each decoder step performing only a part of a turbo decoder step per turbo equalization iteration, such that the first decoder step and the second decoder step are performed in different turbo equalizer iterations, whereby the two decoder steps are connected through the turbo equalizer iterations in such way that when two turbo equalizer iterations are executed, a complete turbo decoding iteration is performed.

A turbo equalizer being capable of performing one or more turbo equalizer iterations consists of an equalizer unit and a decoder unit, which cooperate with each other. A turbo decoder is composed by two - particularly convolutional - decoders iterating between them.

The above mentioned conventional turbo equalizer with turbo decoding system that is depicted in Figure 2, would be one equalizer iteration and one turbo decoder iteration (several iterations between two - convolutional - decoder units), that are executed at each turbo equalizer iteration.

By contrast, the present invention is about a process and arrangement where one equalizer iteration and one (convolutional) decoder (only one part of the turbo decoder) step are performed at each turbo equalizer iteration.

According to the present invention, one turbo decoder step is completed, when two turbo equalizer iterations have been executed.

Preferably, the information derived from the decoding performed in one turbo equalizer iteration is being used to compose turbo equalizer a-priori values ($E^a$) and as decoder a-priori information ($i^1$, $i^2$) used in the subsequent turbo equalizer iteration.

According to another advantage of the present invention, only a single component decoder step, particularly a convolutional decoder step, of the turbo decoder step is performed at each turbo equalizer iteration.

Preferably, turbo equalizer a-priori values ($E^a$) that have been derived from a previous turbo equalizer iteration being used together with a signal (r) received from a signalling channel to compute turbo equalizer extrinsic information ($E^e$).

According to the present invention, two decoder steps are performed during one turbo decoder step, each decoder step performing only a part of a turbo decoder step per turbo equalization iteration, such that the first decoder step and the second decoder step are performed in different turbo equalizer iterations, whereby the two decoder steps are connected through the turbo equalizer iterations.

The principle of the present invention is a novel and low-complexity scheduling for Turbo Equalization with Turbo - Convolutional - Decoding. At each turbo equalizer iteration, only a single component decoder of the turbo code is executed. The component decoders are preferably connected through the turbo equalizer iterations, advantageously in such way that when two turbo equalizer iterations are executed, a complete turbo decoding iteration is performed. Therefore, the main difference of this system compared with the existing turbo equalizer with turbo decoding being described with respect to Figure 2 is that the main effort is spent at the equalizer algorithm at each turbo equalizer iteration. The advantage of the present invention relies on the complexity reduction, since it is not necessary to perform several turbo decoding iterations per turbo equalizer iteration.

According to a second aspect of the present invention, an arrangement for turbo equalization with turbo decoding of signals is provided, said arrangement comprising one equalizer unit and further comprising a first decoder unit for performing only a part of a turbo decoding iteration per turbo equalizer iteration, said decoder unit being interposed between the output and an input of the equalizer unit, and a second decoder unit for performing only a part of a turbo decoding iteration, said second decoder unit being interposed between the output and an input of the equalizer unit, whereby the two decoder units are connected through the iterations of the equalizer unit in such a way that when two turbo equalizer iterations are executed, a complete turbo decoding iteration is performed.

Preferably, said decoder unit is interposed between two turbo equalizer iterations.

Advantageously, the loop between the output and an input of the equalizer unit is an iteration of said equalizer unit.

Furthermore, one turbo equalizer iteration may be comprised by the execution of one equalizer unit and one decoder unit.

According to the present invention, the arrangement further comprises a second decoder unit for performing only a part of a turbo decoding iteration, said second decoder unit being interposed between the output and an input of the equalizer unit, whereby the two decoder units are connected through the iterations of the equalizer unit.

Advantageously, the arrangement further comprises a second decoder unit for performing only a part of a turbo decoding iteration, where the first decoder unit and the second decoder unit are established in different turbo equalizer iterations, whereby the two decoder units are connected through the iterations of the equalizer unit.

The advantage of this arrangement is its low-complexity. Simulations show that the proposed scheme can reach the same asymptotical performance than the conventional one as depicted in Figure 2. The saturation point (Saturation point here is defined as the number of iterations with some Bit Error Rate (BER) gain is present. In other words: it is not possible to have any BER gain with more iterations than the saturation point) of the conventional Turbo Equalizer with Turbo Decoding is lower than the proposed scheme according to the present invention. It means that the novel scheme needs to perform more Turbo Equalizer iterations than the conventional schedule. This fact should be taken into account in the final complexity computation after performing all iterations. The new schedule has a lower complexity per iteration; however it performs more iterations to reach the same performance. It will be shown in the next sections that - particularly when low complexity channel equalization algorithms are used in the turbo decoder - the proposed scheme is significantly less complex.

In the following the invention is described in greater detail by making reference to the accompanied drawings, wherein

Figure 1 depicts a transmitter and multipath channel, which are applicable to those solutions known in the art as well as to the solutions according to the present invention;

Figure 2 illustrates the conventional Turbo Equalization with Turbo Decoding;

Figure 3 depicts the Turbo Equalization with Turbo Decoding according to the present invention;

Figure 4 shows the BER performance of the conventional and novel Turbo Equalizer with Turbo Decoding; and

Figure 5 shows a complexity comparison between the novel Turbo Equalizer with Turbo Decoding and the conventional one.

<u>Introduction and description of the state of the art</u>

Since the invention of the Turbo Equalizer a great effort has been invested in different equalization algorithms for Single Input Single Output (SISO) and Multiple Input Multiple Output (MIMO) antennas systems. The state of the art is to use a Soft Input Soft Output (SfISfO) Equalizer (SISO or MIMO) with a turbo decoder (like in Figure 2). In the conventional system it is necessary to perform several turbo decoding iterations at each Turbo Equalizer iteration, which is inefficient in terms of computational complexity.

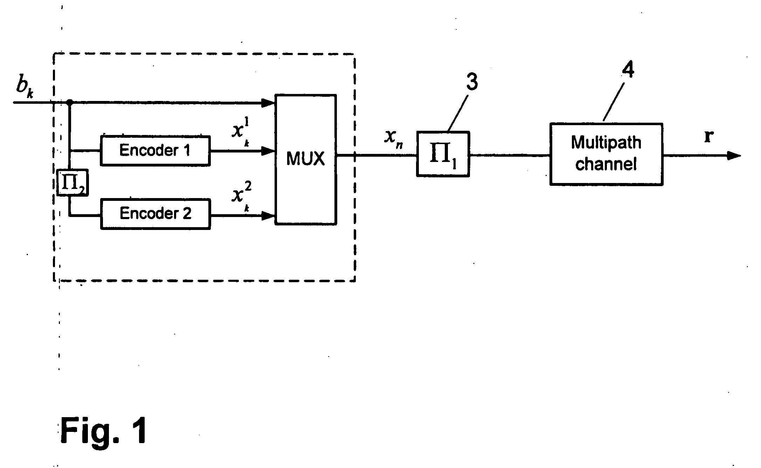

Figure 1 describes a SISO transmission system used to illustrate the conventional Turbo Equalizer with Turbo Decoding and the proposed one; extensions to the MIMO case are easily derived.

The information bits $\mathbf{b}_k$, $k$ = {1, ... $k$, ... $K$} are encoded by a turbo (Parallel Convolutional Code) PCC. The output of the first component Encoder 1 of the turbo code is composed by the systematic bits $b_k$ and the parity bits $x_k^1$. The output of the second component Encoder 2 of the turbo code is composed by the systematic bits $b_k$ and the parity

bits $x_k^2$. The output of both Encoders 1, 2 are multiplexed (MUX) generating the coded symbols $x_n$, $n = \{1, ..., n, ..., N\}$, where $N$ is the frame length size. The coded symbols are interleaved and modulated by a modulator 3. For example, a BPSK modulator can be used. However, the solution according to the present invention can be applied to any modulation. The encoded and modulated bits are transmitted through a multipath channel 4.

Conventional Turbo Equalizer

Figure 2 shows the conventional Turbo Equalizer with Turbo Decoding as mentioned in the introducing part of the specification. Before describing the scheme in greater detail, some quantities are defined:

- $r$ is the received vector from the multipath channel;
- $E^a$ is the a-priori information of the equalizer;
- $E^e$ is the extrinsic information of the equalizer;
- $L^C$ is the channel information of the decoder;
- $i^1$ is the extrinsic information for the information bits at the output of the convolution decoder 1;
- $i^2$ is the extrinsic information for the information bits at the output of the convolution decoder 2;
- $p^1$ is the extrinsic information of the parity bits $x^1$;
- $p^2$ is the extrinsic information of the parity bits $x^2$;

The equalizer unit 5 has two inputs: $r$ and its a-priori information $E^\alpha$, which is equal to zero at the first iteration. The equalizer 5 computes the extrinsic information $E^e$ that is deinterleaved by $\Pi_1^{-1}$ 6 and used as an estimative of $L^C$. $L^C$ is used as input of the Decoder unit 1 and its deinterleaved version 7 is used as input of Decoder unit 2. Only the part correspondent to the information bits is deinterleaved feed to the Decoder 2. The parity bits are not deinterleaved, which is not explicitly shown in Figure 2. The Decoder 1 computes $p^1$ and $i^1$. The convolutional Decoder 2 computes $p^2$ and $i^2$. After several iterations of the turbo decoder, the sum of $i^1$ and $i^2$ is multiplexed (MUX) with $p^1$ and $p^2$ to compose $E^\alpha$. With the a-priori information provided by the turbo decoder, the equalizer can compute a new and more reliable $E^e$ to feed the decoder. This process repeats several times until the output $i^2$ is reliable enough to perform hard decisions.

The concept according to the present invention

The idea of the new schedule is to avoid the use of several turbo decoding iterations per turbo equalizer iteration. It is used only a single component decoder (convolutional decoder) of the turbo decoder at each turbo equalizer iteration. The extrinsic information of the current convolutional decoder is used to compose the a-priori values of the equalizer and as a-priori information of the other component decoder used at the next iteration.
Therefore, only a single convolutional decoder is used per iteration.
Nevertheless, both convolutional decoders are connected through the iterations as in a turbo decoder.

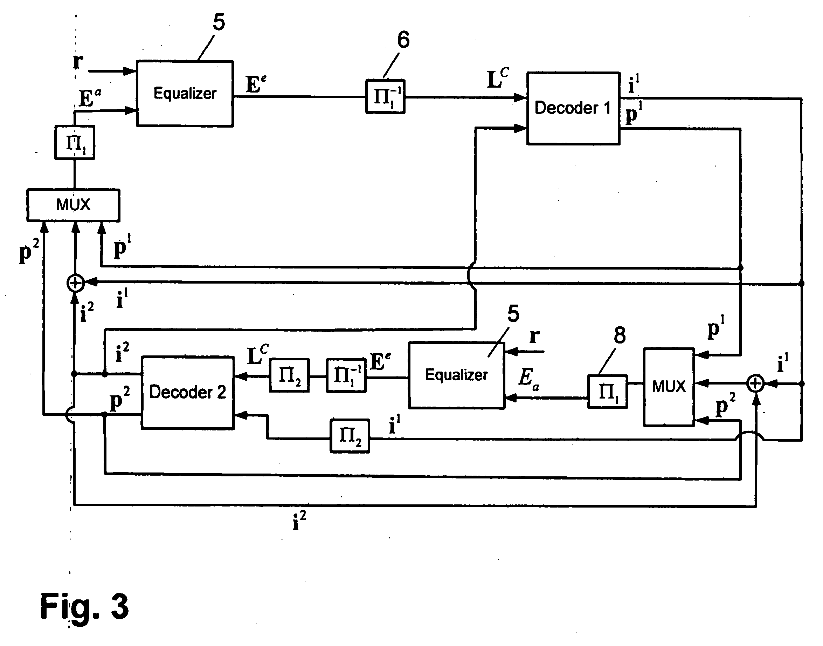

Figure 3 depicts the proposed schedule. First, the received symbols, $r$, from the channel and the equalizer a-priori information, $E^\alpha$, which is equal to zero at the first iteration, feeds the equalizer unit 5 to compute the extrinsic information $E^e$. The equalizer extrinsic information, $E^e$, is deinterleaved (6) and used as an estimative of $L^C$. The first convolutional Decoder unit 1 computes $i^1$ and $p^1$. The values of $i^1$ and $p^1$ are multiplexed (MUX) and interleaved (8) to compose $E^\alpha$.
At the second iteration, the extrinsic information of the equalizer 5 is used as channel information for Decoder unit 2, and the extrinsic information $i^1$ taken from the Decoder 1 in the previous iteration is used as a-priori information for the Decoder 2. The Decoder 2 computes the extrinsic information $p^2$ and $i^2$. The sum of $i^1$ with $i^2$ is multiplexed (MUX) with $p^1$ and $p^2$ to compose the equalizer a-priori information.
In the same way, at the third iteration the a priori information of the equalizer 5 is composed by the sum of $i^1$ with $i^2$ multiplexed with $p^1$ and $p^2$. The same algorithm is repeated for each i iteration, $i = \{1, ... i, ... I\}$.
Table 1 depicts the algorithm of the proposed Turbo Equalizer with Turbo Decoding. In Table 1, the value $q(i)$ indicates which $q$ decoder is decoded at iteration $i$. $q$ equal to 1 means that the component code 1 is decoded at iteration $I$, $q$ equal to 2 means that the component code 2 is decoded at iteration $i$. The operator $E( )$ means the execution of the equalizer algorithm to compute $E^e$. The operator $D( )$ means the execution of the decoding algorithm to compute $i^{q(i)}$ and $p^{q(i)}$. $\Pi_1( )$ and $\Pi_1^{-1}( )$ are respectively the interleaving and deinterleaving operators, where the subscripts 1

refs to the interleaving between the turbo encoder and multipath channel. $\Pi_2$ ( ) and $\Pi_2^{-1}$ ( ) are respectively the interleaving and deinterleaving regarding the turbo code interleaving.

**Table 1**

| Initialization: $\mathbf{E}^a = 0$ and $\mathbf{i}^2 = 0$ |
|---|
| **Iterations:** |
| *for* $i = \{ 0, \dots i, \dots, I-1 \}$ |
| $\quad q(i) = \text{mod}(i,2)+1$, |
| $\quad \mathbf{E}^e = E(\mathbf{r}, \mathbf{E}^a)$, |
| $\quad\quad$ *If* $q(i) = 1$ |
| $\quad\quad\quad \mathbf{L}^C = \Pi_1^{-1}(\mathbf{E}^e)$, |
| $\quad\quad\quad \mathbf{i}^{q(i)}, \mathbf{p}^{q(i)} = D^{q(i)}\left( \mathbf{L}^C, \mathbf{i}^{q(i-1)} \right)$, |
| $\quad\quad$ elseIf $q(i) = 2$ |
| $\quad\quad\quad \mathbf{L}^C = \Pi_2\left( \Pi_1^{-1}(\mathbf{E}^e) \right)^{*}$, |
| $\quad\quad\quad \mathbf{i}^{q(i)}, \mathbf{p}^{q(i)} = D^{q(i)}\left( \mathbf{L}^C, \Pi^2\left( \mathbf{i}^{q(i-1)} \right) \right)$ |
| $\quad\quad$ *endif* |
| $\quad \mathbf{E}^a = \Pi^1\left( mux\left( \mathbf{i}^1 + \mathbf{i}^2, \mathbf{p}^1, \mathbf{p}^2 \right) \right)$, |
| *endfor* |
| **Decision** $\quad \hat{\mathbf{b}} = sign\left( \mathbf{i}^{q(I)} \right)$ |

\* Here the operator $\Pi_2$ ( ) is applied only to the indices regarding the information bits of $\mathbf{L}^C$. The parity bits are not interleaved.

The advantage of the concept according to the present invention

The advantage of this system is its low-complexity. Simulations show that the proposed scheme can reach the same asymptotical performance than the conventional one. The saturation point (Saturation point here is defined as the number of iterations which some Bit Error Rate (BER) gain is present. In other words: it is not possible to have any BER gain with more iterations than the saturation point) of the conventional Turbo Equalizer with Turbo Decoding is lower than the proposed scheme.

It means that the novel scheme according to the present invention needs to perform more Turbo Equalizer iterations than the conventional schedule. This fact should be taken into account in the final complexity computation after performing all iterations. The new schedule has a lower complexity per iteration; however it performs more iterations to reach the same performance. It will be shown in the next sections that when low complexity channel equalization algorithms are used in the turbo decoder, the proposed scheme is significantly less complex.

Application of the concept according to the present invention

The new scheduling can be applied to any detector iterating with a turbo decoder. Simulations show that for a SISO system using a well known Maximum a Posteriori equalizer (MAP), the asymptotical performance of the new and conventional scheduling is the same. Nevertheless, the novel scheme does not bring a reduction of complexity to this specific case since it uses a high complexity equalizer (MAP). However, when a MMSE equalizer is used, for SISO and MIMO case, the proposed scheme is considerably less complex than the conventional one.

In the following it will be presented an example for a MIMO case. A single carrier transmission with the addition of a cyclic prefix is used. Two transmitters with a single antenna transmit at the same time slot and frequency. The receiver is composed by two antennas. The algorithm used in the equalizer is the frequency domain MIMO MMSE equalizer, which is known in the art and therefore, not described in greater detail. The turbo code, of code rate equal to ½, is composed of two identical recursive convolutional code with generators $[7_r, 5]$. The Log-MAP algorithm is used to decode the component codes. For simplicity reasons a BPSK modulator is used. Each user transmits 512 bits (256 information bits and 256 parity bits) after puncturing and interleaving. A S-random interleaver is used with $S = 32$ for the turbo code interleaving and for the interleaving before the multipath channel. The channel is modeled as a twenty equally weighted Rayleigh channel, which is assumed invariant during the frame duration. Both system are simulated, the conventional Turbo Equalizer with Turbo Decoding and the novel one. For the conventional Turbo Equalizer eight iterations were performed at the turbo decoder per turbo equalizer iteration, which is enough to saturate the turbo decoder for this frame length size. The conventional turbo equalizer saturates with three turbo equalizer iterations and the novel one with eight for this setup.

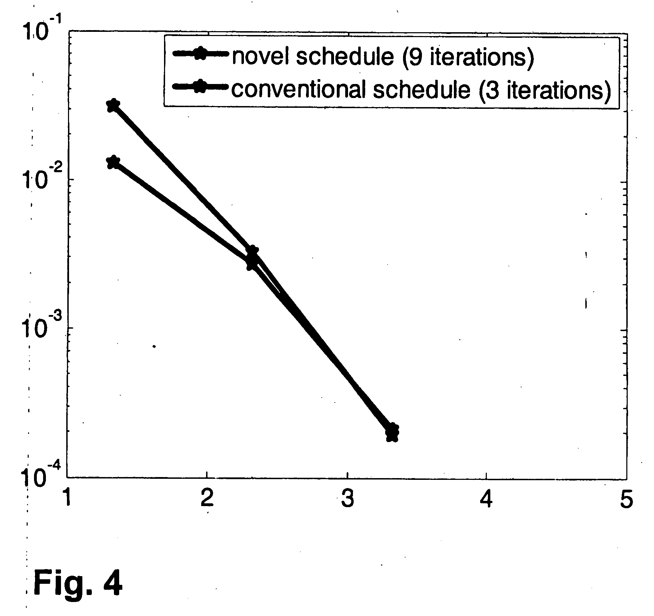

Figure 4 shows the asymptotical performance of both systems. It can be noticed that both schemes are equivalent in terms of performance.

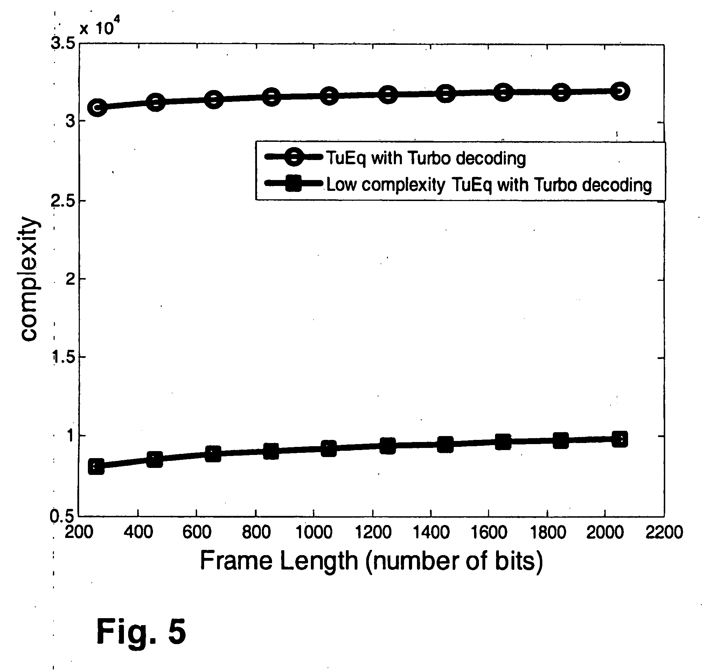

The advantage of the novel scheme according to the present invention can be seen at Figure 5, which shows a roughly estimative of the computational complexity of both schemes.

It can be seen that the novel is less complex than the conventional one. The advantage of complexity of the novel turbo equalizer compared to the conventional one can be further increased when higher codes constraint length and lower complexity equalization algorithms are used. Therefore, the innovations here relies on putting more effort on the equalizer than in the turbo decoding at each iteration, which does not change the asymptotic performance of the Turbo Equalizer, however the complexity is significantly decreased.

**Claims**

1.  Process for turbo equalization with turbo decoding of signals,
    whereby one equalization step is performed at each turbo equalizer iteration and one decoder step, which is only one part of a turbo decoder step, is performed at each turbo equalizer iteration,
    whereby one turbo decoder step is completed when two turbo equalizer iterations have been executed,
    whereby two decoder steps are performed during one turbo decoder step, each decoder step performing only a part of a turbo decoder step per turbo equalization iteration, such that the first decoder step and the second decoder step are performed in different turbo equalizer iterations,
    whereby the two decoder steps are connected through the turbo equalizer iterations in such way that when two turbo equalizer iterations are executed, a complete turbo decoding iteration is performed.

2.  Process according to claim 1, **characterized in that** the information derived from the decoding performed in one turbo equalizer iteration is being used to compose turbo equalizer a-priori values ($E^a$) and as decoder a-priori information ($i^1$, $i^2$) used in the subsequent turbo equalizer iteration.

3.  Process according to claim 1 or 2, **characterized in that** only a single component decoder step, particularly a convolutional decoder step, of the turbo decoder step is performed at each turbo equalizer iteration.

4.  Process according to any one of claims 1 to 3, **characterized in that** turbo equalizer a-priori values ($E^a$) that have been derived from a previous turbo equalizer iteration being used together with a signal (r) received from a signalling channel to compute turbo equalizer extrinsic information ($E^e$).

5. Arrangement for turbo equalization with turbo decoding of signals, said arrangement comprising one equalizer unit (5) and further comprising a first decoder unit (1) for performing only a part of a turbo decoding iteration per turbo equalizer iteration, said decoder unit (1) being interposed between the output and an input of the equalizer unit(5), and a second decoder unit (2) for performing only a part of a turbo decoding iteration, said second decoder unit (2) being interposed between the output and an input of the equalizer unit (5), whereby the two decoder units (1, 2) are connected through the iterations of the equalizer unit (5) in such a way that when two turbo equalizer iterations are executed, a complete turbo decoding iteration is performed.

6. Arrangement according to claim 5, **characterized in that** said decoder unit (1) being interposed between two turbo equalizer iterations.

7. Arrangement according to claim 5 or 6, **characterized in that** the loop between the output and an input of the equalizer unit (5) is an iteration of said equalizer unit (5).

8. Arrangement according to any one of claims 5 to 7, **characterized in that** one turbo equalizer iteration is comprised by the execution of one equalizer unit (5) and one decoder unit (1).

9. Arrangement according to any one of claims 5 to 8, **characterized in that** it further comprises a second decoder unit (2) for performing only a part of a turbo decoding iteration, where the first decoder unit (1) and the second decoder unit (2) are established in different turbo equalizer iterations, whereby the two decoder units (1, 2) are connected through the iterations of the equalizer unit. (5).

**Patentansprüche**

1. Verfahren zur Turbo-Entzerrung mit Turbo-Dekodierung von Signalen, wobei ein Entzerrungs-Schritt bei jeder Turbo-Entzerrungs-Iteration ausgeführt wird und ein Dekodier-Schritt, welcher nur ein Teil eines Turbo-Dekodier-Schritts ist, bei jeder Turbo-Entzerrungs-Iteration ausgeführt wird,
wobei ein Turbo-Dekodier-Schritt komplettiert ist, wenn zwei Turbo-Entzerrungs-Iterationen durchgeführt worden sind,
wobei während eines Turbo-Dekodier-Schritts zwei Dekodier-Schritte ausgeführt werden, wobei jeder Dekodier-Schritt pro Turbo-Entzerrungs-Iteration nur einen Teil eines Turbo-Dekodier-Schritts ausführt, so dass der erste Dekodier-Schritt und der zweite Dekodier-Schritt in verschiedenen Turbo-Entzerrungs-Iterationen ausgeführt werden,
wobei die zwei Dekodier-Schritte durch die Turbo-Entzerrungs-Iterationen verbunden sind, derart, dass wenn zwei Turbo-Entzerrungs-Iterationen durchgeführt sind, eine komplette Turbo-Dekodier-Iteration ausgeführt ist.

2. Verfahren nach Anspruch 1, **dadurch gekennzeichnet, dass** die Informationen, die von der in einer Turbo-Entzerrungs-Iteration ausgeführten Dekodierung herrühren, genutzt werden, um Turbo-Entzerrungs-A-Priori Werte ($E^a$) zu entwerfen und als Dekodier-A-Priori Informationen ($i^1$, $i^2$), die in der nachfolgenden Turbo-Entzerrungs-Iteration verwendet werden.

3. Verfahren nach Anspruch 1 oder 2, **dadurch gekennzeichnet, dass** nur ein EinKomponenten-Dekodier-Schritt, insbesondere ein Konvolutions-Dekodier-Schritt, des Turbo-Dekodier-Schritts bei jeder Turbo-Entzerrungs-Iteration ausgeführt wird.

4. Verfahren nach einem der Ansprüche 1 bis 3, **dadurch gekennzeichnet, dass** Turbo-Entzerrungs-A-Priori Werte ($E^a$), die von einer vorhergehenden Turbo-Entzerrungs-Iteration herrühren, zusammen mit einem Signal (r), das von einem Signalisierungskanal erhalten wird, verwendet werden, um extrinsische Turbo-Entzerrungs-Informationen ($E^e$) zu errechnen.

5. Anordnung zur Turbo-Entzerrung mit Turbo-Dekodierung von Signalen, aufweisend eine Entzerrer-Einheit (5) und weiterhin aufweisend eine erste Dekodier-Einheit (1) zur Ausführung nur eines Teils einer Turbo-Dekodier-Iteration pro Turbo-Entzerrungs-Iteration, wobei die Dekodier-Einheit (1) zwischen dem Ausgang und einem Eingang der Entzerrer-Einheit (5) zwischengeschaltet ist, und eine zweite Dekodier-Einheit (2) zur Ausführung nur eines Teils einer Turbo-Dekodier-Iteration, wobei die zweite Dekodier-Einheit (2) zwischen dem Ausgang und einem Eingang der Entzerrer-Einheit (5) zwischengeschaltet ist, wobei die zwei Dekodier-Einheiten (1, 2) durch die Iterationen der Entzerrer-Einheit (5) derart verbunden sind, dass wenn zwei Turbo-Entzerrungs-Iterationen durchgeführt sind, eine komplette Turbo-Dekodier-Iteration ausgeführt ist.

6. Anordnung nach Anspruch 5, **dadurch gekennzeichnet, dass** die Dekodier-Einheit (1) zwischen zwei Turbo-Entzerrungs-Iterationen zwischengeschaltet ist.

7. Anordnung nach Anspruch 5 oder 6, **dadurch gekennzeichnet, dass** die Schleife zwischen dem Ausgang und einem Eingang der Entzerrer-Einheit (5) eine Iteration der Entzerrer-Einheit (5) ist.

8. Anordnung nach einem der Ansprüche 5 bis 7, **dadurch gekennzeichnet, dass** eine Turbo-Entzerrungs-Iteration die Ausführung einer Entzerrer-Einheit (5) und einer Dekodier-Einheit (1) aufweist.

9. Anordnung nach einem der Ansprüche 5 bis 8, **dadurch gekennzeichnet, dass** weiterhin eine zweite Dekodier-Einheit (2) vorgesehen ist, um nur einen Teil einer Turbo-Dekodier-Iteration auszuführen, wobei die erste Dekodier-Einheit (1) und die zweite Dekodier-Einheit (2) in verschiedenen Turbo-Entzerrungs-Iterationen vorgesehen sind, wobei die zwei Dekodier-Einheiten (1, 2) durch die Iterationen der Entzerrer-Einheit (5) verbunden sind.

**Revendications**

1. Procédé d'égalisation rapide avec décodage rapide de signaux,
par lequel une étape d'égalisation est mise en oeuvre à chaque itération d'égaliseur rapide et une étape de décodeur, qui représente uniquement une partie d'une étape de décodeur rapide, est mise en oeuvre à chaque itération d'égaliseur rapide,
par lequel une étape de décodeur rapide est achevée lorsque deux itérations d'égaliseur rapide ont été exécutées,
par lequel deux étapes de décodeur sont mises en oeuvre au cours d'une étape de décodeur rapide, chaque étape de décodeur mettant en oeuvre uniquement une partie d'une étape de décodeur rapide par itération d'égalisation rapide, de telle sorte que la première étape de décodeur et la seconde étape de décodeur sont mises en oeuvre au cours d'itérations d'égaliseur rapide différentes,
par lequel les deux étapes de décodeur sont couplées par l'intermédiaire des itérations d'égaliseur rapide de telle manière que lorsque deux itérations d'égaliseur rapide sont exécutées, une itération de décodeur rapide complète est exécutée.

2. Procédé selon la revendication 1, **caractérisé en ce que** les informations déduites du décodage mis en oeuvre sur une itération d'égaliseur rapide sont utilisées afin de composer des valeurs a priori d'égaliseur rapide ($E^a$) et en tant qu'informations a priori de décodeur ($i^1$, $i^2$) utilisées dans l'itération d'égaliseur rapide suivante.

3. Procédé selon la revendication 1 ou 2, **caractérisé en ce qu'**une étape de décodeur de composante unique, en particulier, une étape de décodeur de convolution, de l'étape de décodeur rapide est mise en oeuvre à chaque itération d'égaliseur rapide.

4. Procédé selon l'une quelconque des revendications 1 à 3, **caractérisé en ce que** des valeurs a priori d'égaliseur rapide ($E^a$) qui ont été déduites d'une itération d'égaliseur rapide antérieure sont utilisées ensemble avec un signal (r) reçu à partir d'un canal de signalisation afin de calculer des informations extrinsèques d'égaliseur rapide ($E^e$).

5. Agencement d'égalisation rapide avec décodage rapide de signaux, ledit agencement comprenant une unité formant égaliseur (5) et comprenant, en outre, une première unité formant décodeur (1) afin de mettre en oeuvre uniquement une partie d'une itération de décodage rapide par itération d'égaliseur rapide, ladite unité formant décodeur (1) étant interposée entre la sortie et une entrée de l'unité formant égaliseur (5), et une seconde unité formant décodeur (2) destinée à mettre en oeuvre uniquement une partie d'une itération de décodage rapide, ladite seconde unité formant décodeur (2) étant interposée entre la sortie et une entrée de l'unité formant égaliseur (5), de telle sorte que les deux unités formant décodeur (1, 2) sont couplées par l'intermédiaire des itérations de l'unité formant égaliseur (5) de telle manière que lorsque deux unités d'itération d'égaliseur rapide sont exécutées, une itération de décodage rapide complète est mise en oeuvre.

6. Agencement selon la revendication 5, **caractérisé en ce que** ladite unité formant décodeur (1) est interposée entre deux itérations d'égaliseur rapide.

7. Agencement selon la revendication 5 ou 6, **caractérisé en ce que** la boucle entre la sortie et une entrée de l'unité formant égaliseur (5) correspond à une itération de ladite unité formant égaliseur (5).

8. Agencement selon l'une quelconque des revendications 5 à 7, **caractérisé en ce qu'**une itération d'égaliseur rapide est constituée par l'exécution d'une unité formant égaliseur (5) et d'une unité formant décodeur (1).

9. Agencement selon l'une quelconque des revendications 5 à 8, **caractérisé en ce qu'**il comprend, en outre, une seconde unité formant décodeur (2) destinée à mettre en oeuvre uniquement une partie d'une itération de décodage rapide, dans lequel la première unité formant décodeur (1) et la seconde unité formant décodeur (2) sont établies dans différentes itérations d'égaliseur rapide, de telle sorte que les deux unités formant décodeur (1, 2) sont couplées par l'intermédiaire des itérations de l'unité formant égaliseur (5).

**Fig. 1**

EP 1 906 610 B1

**Fig. 2**

EP 1 906 610 B1

**Fig. 3**

EP 1 906 610 B1

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Lee F.K.H et al.** Parallel-Trellis Turbo Equalizers for Sparse Coded Transmission over Sparse Multipath Channels - ICC 2003, 2003 IEEE International conference on Communications. *Anchorage,* 11 May 2003, vol. 1-5, 2943-2947